# EUROPÄISCHE PATENTSCHRIFT

(11) **EP 2 662 334 B1**
(45) Veröffentlichungstag und Bekanntmachung des Hinweises auf die Patenterteilung: **25.11.2015**
(21) Anmeldenummer: 13166270.2
(22) Anmeldetag: 02.05.2013
(51) Int. Cl.: C01B 33/03, C01B 33/02, C23C 16/24, C23C 16/442

(54) **POLYKRISTALLINES SILICIUMGRANULAT UND SEINE HERSTELLUNG**
GRANULAR POLYCRYSTALLINE SILICON AND PRODUCTION THEREOF
GRANULÉS DE SILICIUM POLYCRISTALLIN ET LEUR FABRICATION

(30) Priorität: 07.05.2012 DE 102012207505
(43) Veröffentlichungstag der Anmeldung: 13.11.2013
(73) Patentinhaber: Wacker Chemie AG, 81737 München (DE)
(72) Erfinder: Hertlein, Harald, 84489 Burghausen (DE); Hauswirth, Rainer, 84375 Kirchdorf (DE); Weidhaus, Dieter, 84489 Burghausen (DE)
(74) Vertreter: Potten, Holger

(56) Entgegenhaltungen:
- US-A- 5 077 028
- US-A- 5 139 762
- US-A1- 2012 100 059

## Beschreibung

Die Erfindung betrifft ein polykristallines Siliciumgranulat und seine Herstellung.

Polykristallines Siliciumgranulat oder kurz Polysiliciumgranulat ist eine Alternative zum im Siemens-Verfahren hergestellten Polysilicium. Während das Polysilicium im Siemens-Verfahren als zylindrischer Siliciumstab anfällt, der vor seiner Weiterverarbeitung zeit- und kostenaufwändig zu so genanntem Chippoly zerkleinert und ggf. wiederum gereinigt werden muss, besitzt Polysiliciumgranulat Schüttguteigenschaften und kann direkt als Rohmaterial z.B. zur Einkristallerzeugung für die Photovoltaik- und Elektronikindustrie eingesetzt werden.

Polysiliciumgranulat wird in einem Wirbelschichtreaktor produziert. Dies geschieht durch Fluidisierung von Siliciumpartikeln mittels einer Gasströmung in einer Wirbelschicht, wobei diese über eine Heizvorrichtung auf hohe Temperaturen aufgeheizt wird. Durch Zugabe eines siliciumhaltigen Reaktionsgases erfolgt eine Pyrolysereaktion an der heißen Partikeloberfläche. Dabei scheidet sich elementares Silicium auf den Siliciumpartikeln ab und die einzelnen Partikel wachsen im Durchmesser an. Durch den regelmäßigen Abzug von angewachsenen Partikeln und Zugabe kleinerer Siliciumpartikel als Keimpartikel (im weiteren Verlauf des Dokuments "Seed" genannt) kann das Verfahren kontinuierlich mit allen damit verbundenen Vorteilen betrieben werden. Als siliciumhaltiges Eduktgas sind Silicium-Halogenverbindungen (z.B. Chlorsilane oder Bromsilane), Monosilan (SiH₄), sowie Mischungen dieser Gase mit Wasserstoff beschrieben. Derartige Abscheideverfahren und Vorrichtungen hierzu sind beispielsweise aus US4,786,477 bekannt.

Das aus den Abscheideverfahren erhaltene Siliciumgranulat zeichnet sich durch hohe Reinheit, d.h. durch einen niedrigen Gehalt an Dotierstoffen (insbesondere Bor und Phosphor), Kohlenstoff und Metallen aus.

Aus US 4,883,687 ist ein Siliciumgranulat bekannt, das anhand der Korngrößenverteilung, des Bor-, Phosphor- und Kohlenstoffgehalts, des Oberflächenstaubgehalts, seiner Dichte und Schüttdichte definiert ist.

In US 4,851,297 ist ein dotiertes Polysiliciumgranulat beschrieben, in US 5,242,671 ein Polysiliciumgranulat mit reduziertem Wasserstoffgehalt.

US 5,077,028 beschreibt ein Verfahren, bei dem ein Polysiliciumgranulat, welches sich durch einen niedrigen Chlorgehalt auszeichnet, aus einem Chlorsilan abgeschieden wird.

Das heute in großem Maßstab produzierte Polysiliciumgranulat hat eine poröse Struktur und daraus resultierend zwei gravierende Eigenschaftsnachteile:

In den Poren ist Gas eingeschlossen. Dieses Gas wird beim Aufschmelzen frei und stört die Weiterverarbeitung des Polysiliciumgranulats. Es wird daher versucht, den Gasgehalt des Polysiliciumgranulats zu reduzieren. Dabei ist aber, wie in US 5,242,671 beschrieben, ein zusätzlicher Arbeitsschritt nötig, was die Herstellkosten erhöht und zudem eine zusätzliche Kontamination des Granulats bewirkt.

Das Polysiliciumgranulat ist nicht besonders abriebsfest. Das bedeutet, dass bei der Handhabung des Granulats z.B. beim Transport zum Anwender feiner Siliciumstaub entsteht. Dieser Staub stört in mehrfacher Hinsicht:
Er stört bei der Weiterverarbeitung des Polysiliciumgranulats, da er beim Aufschmelzen des Granulats aufschwimmt;
er stört beim Transport des Polysiliciumgranulats innerhalb der Produktionsanlage, weil er eine Belagbildung an Rohrleitungen verursacht und es zu einem Verblocken von Armaturen kommt;
er ist aufgrund seiner großen spezifischen Oberfläche ein potentieller Kontaminationsträger.
Der Abrieb führt bereits bei der Herstellung des Polysiliciumgranulats in der Wirbelschicht zu Verlusten.

Nachteiligerweise entsteht bei der Herstellung auf Basis von Monosilan als siliciumhaltigem Eduktgas zusätzlich zum Abrieb im Abscheideprozess direkt amorpher Silicium- Staub als Folge einer homogenen Gasphasenreaktion.

Dieser Feinststaub kann zwar teilweise vom Produkt abgetrennt werden, was aber ebenfalls Aufwand, Materialverlust und damit Zusatzkosten bedeutet.

Aus US 7,708,828 ist ein polykristallines Siliciumgranulat bekannt, welches aus Partikeln besteht, die eine Dichte größer als 99,9 % der theoretischen Feststoffdichte und damit einen Porenanteil kleiner als 0,1 % sowie eine Oberflächenrauhigkeit Rₐ kleiner als 150 nm besitzen. Bevorzugt haben die Partikel einen Dotierstoffgehalt an Bor kleiner als 300 ppta, bevorzugt kleiner als 100 ppta. Bevorzugt haben die Partikel einen Gehalt an Kohlenstoff kleiner als 250 ppba, bevorzugt kleiner als 100 ppba. Bevorzugt haben die Partikel einen Gesamtgehalt an den Metallen Fe, Cr, Ni, Cu, Ti, Zn und Na von weniger als 50 ppbw, bevorzugt weniger als 10 ppbw.

Das erfindungsgemäße Polysiliciumgranulat lässt sich vorzugsweise in einem strahlungsbeheizten Fließbettreaktor herstellen.

Vorzugsweise wird das erfindungsgemäße hochreine polykristalline Siliciumgranulat durch Abscheiden eines Reaktionsgases auf Keimkristallen aus Silicium in einem Fließbett hergestellt. Das Reaktionsgas besteht bevorzugt aus einer Mischung von Wasserstoff und siliciumhaltigem Gas, bevorzugt Halogensilanen, besonders bevorzugt aus einer Mischung von Wasserstoff und Trichlorsilan (TCS). Die Abscheidung erfolgt vorzugsweise bei einer Temperatur der Wirbelschicht im Reaktionsbereich von 700°C bis 1200 °C. Die vorgelegten Keimkristalle in der Wirbelschicht werden mit Hilfe eines siliciumfreien Fluidisiergases, vorzugsweise Wasserstoff, fluidisiert und mittels Temperaturstrahlung erhitzt. Die Wärmeenergie wird mittels flächiger Heizstrahler gleichmäßig über den Umfang des Fließbettes eingetragen. In der Reaktionszone wird das siliciumhaltige Reaktionsgas aufgrund einer CVD-Reaktion als elementares Silicium auf den Siliciumteilchen abgelagert. Nicht abreagiertes Reaktionsgas, Fluidisierungsgas und gasförmige Nebenreaktionsprodukte werden aus dem Reaktor entfernt. Durch regelmäßiges Abziehen von mit dem abgelagerten Silicium versehenen Partikeln aus dem Fließbett und Zugabe von Keimkristallen kann das Verfahren kontinuierlich betrieben werden.

Die Temperatur der Wirbelschicht im Reaktionsbereich beträgt bevorzugt von 850°C bis 1100°C, besonders bevorzugt von 900°C bis 1050 °C, ganz besonders bevorzugt von 900°C bis 970°C.

Das Reaktionsgas kann über eine oder mehrere Düsen in die Wirbelschicht eingedüst werden.

Die Konzentration des siliciumhaltigen Reaktionsgases beträgt bezogen auf die gesamte Gasmenge durch die Wirbelschicht vorzugsweise 10 mol% bis 50 mol%, besonders bevorzugt 15 mol% bis 40 mol%. Die Konzentration des siliciumhaltigen Reaktionsgases in der Reaktionsgasdüse beträgt bezogen auf die gesamte Gasmenge durch die Reaktionsgasdüsen vorzugsweise von 20 mol% bis 65 mol%, besonders bevorzugt von 30 mol% bis 65 mol%, ganz besonders bevorzugt 40 mol% bis 60 mol%.

Bei der Herstellung des Polysiliciumgranulats tritt nur eine geringe Staubbildung auf. Diese sowie der geringere Abrieb führen zu erhöhten Ausbeuten, da kaum Feinstaub aus der Wirbelschicht ausgetragen wird, der bei bekannten Verfahren immer zu einem Materialverlust führt.

Allerdings weist das aus dem Stand der Technik bekannte Polysiliciumgranulat keine besonders guten Zieheigenschaften (Schmelzeigenschaften, Ansetzhäufigkeiten, Ansetzzeiten) auf. Eine Beschreibung des Problems der Ansetzhäufigkeit und Ansetzzeit findet sich z.B. im Patent der Wacker Siltronic AG, DE 10025870A1, Absatz 0004, 0016 und 0018 und in DE19847695A1.

Ein Teil zur Lösung des Problems ist die Herstellung von Granulat mit deutlich größeren Granulat-Partikelgrößen. Herstellungsverfahren für große Granulat-Partikelgrößen erfordern sehr hohe Gasmengen zur Fluidisierung im Wirbelschichtreaktor. Durch die größere Feststoffbewegung kommt es bei Wirbelschichten ohne Festbettzone im Bodenbereich offenbar zu Verunreinigungen durch den Bodenbereich.

Für die Herstellung von hochreinem Polysiliciumgranulat werden hochreine Keimkristalle (Seed) benötigt.

Hochrein mahlende Luftstrahlmühlen - wie in US7,490,785 beschrieben - sind für große Partikelgrößen mit einem Massenbezogenen Medianwert von größer 1250 µm nicht mehr einsetzbar.

Die bisherige technische Lösung ist der Einsatz eines Walzenbrechers. Laut dem Abstract zu JP 57-067019 (Shin Etsu Hondatai) erhält man Siliciumseedpartikel aus Siliciumgranulat, indem man dieses in einem Doppel-Walzenbrecher zerkleinert und anschließend über eine Siebung fraktioniert.

Eine Kontamination der Siliciumseedpartikel mit anderen Elementen, wird dadurch verhindert, dass die Oberfläche der Walzen mit einer Schicht aus Silicium versehen ist. Die Materialpaarung Silicium-Silicium zwischen Walze und Mahlgut führt jedoch zu einem hohen Verschleiß der Siliciumschicht auf den Walzen, so dass nur kurze Laufzeiten der Maschine möglich sind, bis die Walzen ausgetauscht werden müssen. Eine wirtschaftliche Herstellung von Seed ist somit nicht möglich.

Eine wesentliche Verbesserung hinsichtlich des Walzenverschleißes bringt der Einsatz von Walzen mit einer Hartmetalloberfläche und abgestimmter Walzenspaltgeometrie wie er in DE 102004048948 beschrieben ist, dabei kommt es allerdings zu einer Kontamination des Seed mit B, C, Zn, Ti, Mg, W, Fe, Co, Sb und Zr.

Der Einsatz eines Seedgemisches aus Siebunterkorn und mit Walzenbrecher gemahlenem Seed sorgt zwar für eine verringerte Kontamination, diese ist aber immer noch zu hoch für Verfahren wie das GFZ-Ziehen oder für Tiegelziehverfahren in der Halbleiterindustrie. Gegenstand des GFZ-Verfahrens (Granular Float Zone) ist die Herstellung eines Einkristalls aus Silicium unter Verwendung von geschmolzenem Granulat. Das Verfahren und Vorrichtungen, die zu dessen Durchführung geeignet sind, sind beispielweise in der DE102010006724A1 beschrieben.

US 5 077 028 A und US 2012/100059 A1 offenbaren Verfahren zur Herstellung von polykristallinem Siliciumgranulat in einem Wirbelschichtreaktor.

Aus der beschriebenen Problematik ergab sich die Aufgabenstellung der Erfindung.

Die Aufgabe wird gelöst durch polykristallines Siliciumgranulat, umfassend eine kompakte Matrix und eine Oberflächenschicht enthaltend nadelförmige, parallel angeordnete Kristallite.

Das erfindungsgemäße Polysiliciumgranulat ist vorzugsweise frei von Einschlüssen von Feinstpartikeln im Größenbereich von kleiner 10 µm.

Insbesondere weist das Polysiliciumgranulat keine Partikel im Nanometerbereich auf.

Im Stand der Technik führten diese Feinstpartikel in der Siliciumkugel zu Problemen im Aufschmelzverhalten, Versetzungsrate, Ansetzhäufigkeit, Lebensdauerwerte, Kristalldefekte und Ziehperformance.

Das erfindungsgemäße Polysiliciumgranulat kann in der kompakten Matrix nadelig-radialstrahlige Kristallaggregate einer Kristallitgröße von 0,001 bis 200 µm aufweisen.

Vorzugsweise beträgt die Kristallitgröße 0,01 bis 4 µm.

Der Wasserstoffgehalt des Silicium-Granulat liegt im Bereich 0,01 bis 40 ppmw, bevorzugt 0,01 bis 35 ppmw und besonders bevorzugt von 0,01 bis 0,2 ppmw.

Der Chloridwert des Polysiliciumgranulats liegt vorzugsweise im Bereich von 9 bis 39 ppmw, besonders bevorzugt von 21 bis 35 ppmw und besonders bevorzugt von 21 bis 30 ppmw.

Der gesamte Kohlenstoffgehalt im Polysiliciumgranulat ist 0,0015 bis 0,09 ppma, bevorzugt 0,0015 bis 0,02 ppma und ganz besonders bevorzugt von 0,0015 bis 0,015 ppma.

Der Kohlenstoffgehalt im Bulk des Polysiliciumgranulats liegt im Bereich von 0,0005 bis 0,01 ppma, bevorzugt im Bereich von 0,0005 bis 0,005 ppma.

Der Fluorgehalt im Polysiliciumgranulat liegt im Bereich von 0,0005 bis 1 ppma, bevorzugt im Bereich 0,0005 bis 0,2 ppma.

Der Borgehalt im Polysiliciumgranulat liegt im Bereich 0,001 bis 0,09 ppba, bevorzugt 0,001 bis 0,008 ppba.

Das Polysiliciumgranulat umfasst einen Metallgehalt von Zn, Ti, Mg, Zr, W, Fe, Co, Sb in Summe im Bereich von 0,001 bis 1,5 ppbw, besonders bevorzugt im Bereich von 0,03 bis 1,0 ppbw.

Dabei ist der Gehalt an Zn im Bereich von 0,001 bis 0,4 ppbw, besonders bevorzugt im Bereich von 0,01 bis 1,0 ppbw und besonders bevorzugt im Bereich von 0,01 bis 0,1 ppbw.

Der Gehalt an Ti ist vorzugsweise im Bereich von 0,0001 bis 0,5 ppbw.

Der Gehalt an Mg ist vorzugsweise im Bereich von 0,0001 bis 0,1 ppbw.

Der Gehalt an Zr ist vorzugsweise im Bereich von 0,0001 bis 0,02 ppbw.

Der Gehalt an W ist vorzugsweise im Bereich von 0,0001 bis 0,05 ppbw.

Der Gehalt an Fe ist vorzugsweise im Bereich von 0,0001 bis 0,1 ppbw, besonders bevorzugt im Bereich von 0,0001 bis 0,05 ppbw.

Der Gehalt an Co ist vorzugsweise im Bereich von 0,00001 bis 0,002 ppbw.

Der Gehalt an Sb ist vorzugsweise im Bereich von 0,0001 bis 0,007 ppbw.

Der Gehalt an N₂ ist im Bereich von 1E+18 At/cm³ bis 1E+15 At/cm³.

Der Feinstaubgehalt liegt im Bereich von 0,01 bis 10 ppmw.

Die spezifische Oberfläche ist im Bereich von 0,1 bis 30 cm²/g, besonders bevorzugt im Bereich von 1 bis 25 cm²/g und ganz besonders bevorzugt im Bereich von 1,5 bis 15 cm²/g.

Das Polysiliciumgranulat wird einer Oberflächenbehandlung ausgesetzt, wodurch es eine veränderte Kristallstruktur erhält.

In einer Ausführungsform umfasst die Matrix dabei nadelig-radialstrahlige Kristallaggregate, wohingegen die Oberflächenschicht nadelförmige, parallel angeordnete Kristallite umfasst.

Die Erfindung betrifft jedoch auch polykristallines Silicium-granulat, bei dem sowohl die Matrix als auch die Oberflächenschicht nadelförmige, parallel angeordnete Kristallite umfassen.

Überraschenderweise haben die Erfinder eine Korrelation zwischen Granulatgröße und Ansetzzeit, Ansetzhäufigkeit und versetzungsfreier Ausbeute in der Weiterverarbeitung zum Einkristall festgestellt. Unter der Ansetzhäufigkeit versteht man die Anzahl der notwendigen Versuche zur Herstellung eines versetzungsfreien Einkristalls, unter Ansetzzeit die Zeit vom ersten Kontakt des Impflingskristalls mit der Siliciumschmelze bis zum Abschluß des Ziehens des Dünnhalskristalls (siehe DE19847695A1). An dem Einkristall, hergestellt mit erfindungsgemäßem Polysiliciumgranulat, werden deutlich höhere Lebensdauerwerte gemessen.

Es wird vorzugsweise in GFZ- (600-4000 µm, bevorzugt über 98 Massenprozent im Bereich 600-2000 µm, mit einem massenbezogenen Medianwert im Bereich 1200 bis 2600 µm) und Tiegelziehverfahren (600-8000 µm, bevorzugt über 98 Massenprozent im Bereich 600-4000 µm, mit einem massenbezogenen Medianwert im Bereich 1200 bis 2600 µm) eingesetzt.

Zudem weist das erfindungsgemäße Polysiliciumgranulat - wie zuvor beschrieben - einen niedrigen Wasserstoff-Gehalt auf. Eine thermische Nachbehandlung des Granulatpolysiliciums ist nicht erforderlich. Dies führt zu deutlich geringerem Spritzen beim Aufschmelzen. Das Silicium-Granulat lässt sich, durch Einsparung eines thermischen Nachbehandlungsschrittes mit hohen Temperaturen, kostengünstiger herstellen.

Das erfindungsgemäße Polysiliciumgranulat weist vorzugsweise eine dünne Oxidschicht auf der Oberfläche auf. Die Dicke der Oxidschicht beträgt vorzugsweise weniger als 3 Atomlagen und führt zu besserem Aufschmelzverhalten, geringeren Versetzungsraten und weniger Kristalldefekten.

Weiterhin weist das erfindungsgemäße Polysiliciumgranulat - wie zuvor beschrieben - vorzugsweise einen Chlorgehalt von 9-39 ppmw auf. Dies führt zu einem verbesserten Aufschmelzverhalten. Metallische Verunreinigungen werden während der Aufschmelzphase ausgetragen.

Bei der Herstellung des erfindungsgemäßen Polysiliciumgranulats wird die Gasphase in einem Temperaturbereich zwischen 900 und 970°C und mit einem TCS-Anteil in Wasserstoff von 20,5 bis 24 mol% (Sättigung: mol (TCS)/ mol (TCS+H₂)) eingestellt.

Unter diesen Reaktionsbedingungen entstehen in der Gasphase kristalline Nano-Siliciumpartikel, die aufgrund der Reaktionsbedingungen und der gleichzeitig sehr hoch eingestellten Gasgeschwindigkeit im Bereich 0,7 bis 2,1 m/s, vorzugsweise 0,8 bis 1,2 m/s, nicht in das Granulat-Silicium eingebaut, sondern mit dem Gasstrom aus dem Reaktor ausgetragen werden.

Im Gegensatz dazu wurden im Stand der Technik diese Nano-Siliciumpartikel in die Granulat-Siliciumpartikel eingebaut und verursachen bei der Weiterverarbeitung in der Halbleiterindustrie Versetzungen.

Im erfindungsgemäßen Verfahren werden diese kristallinen Nano-Siliciumpartikel mit dem Abgas aus dem Reaktor ausgetragen.

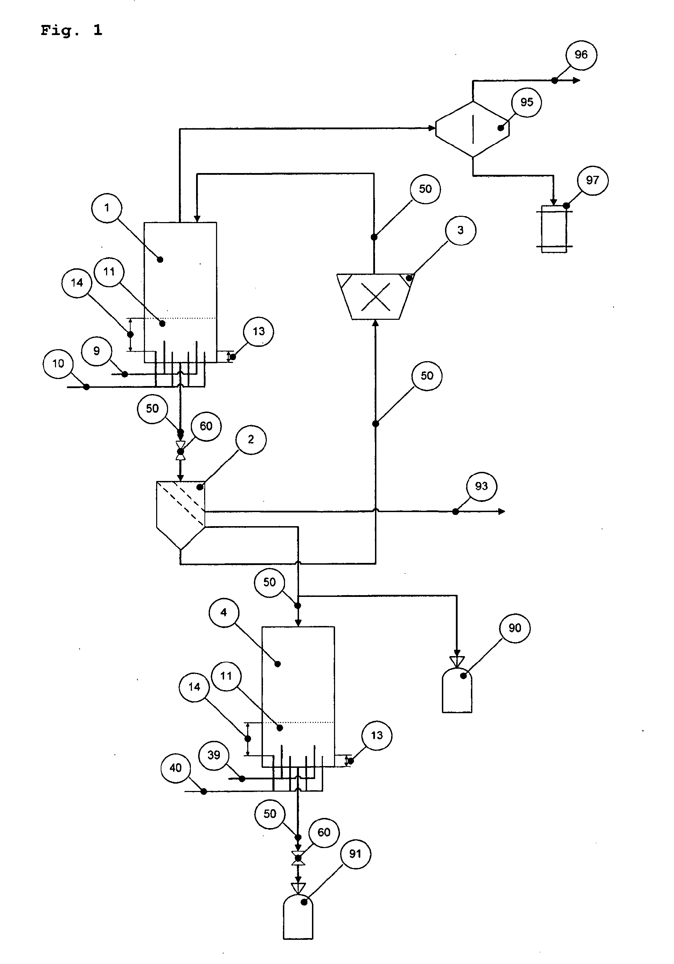

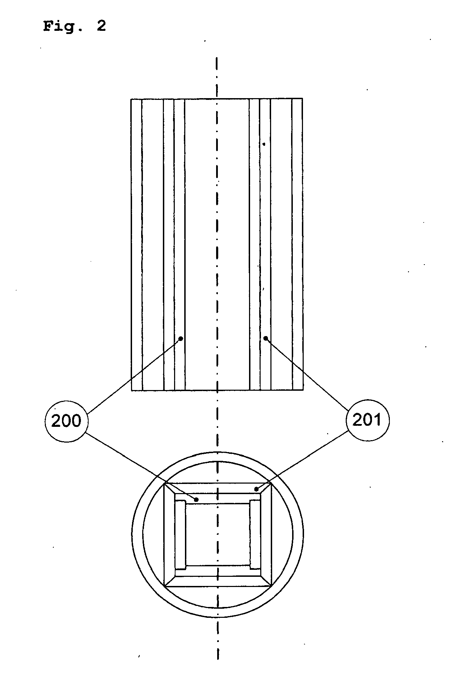

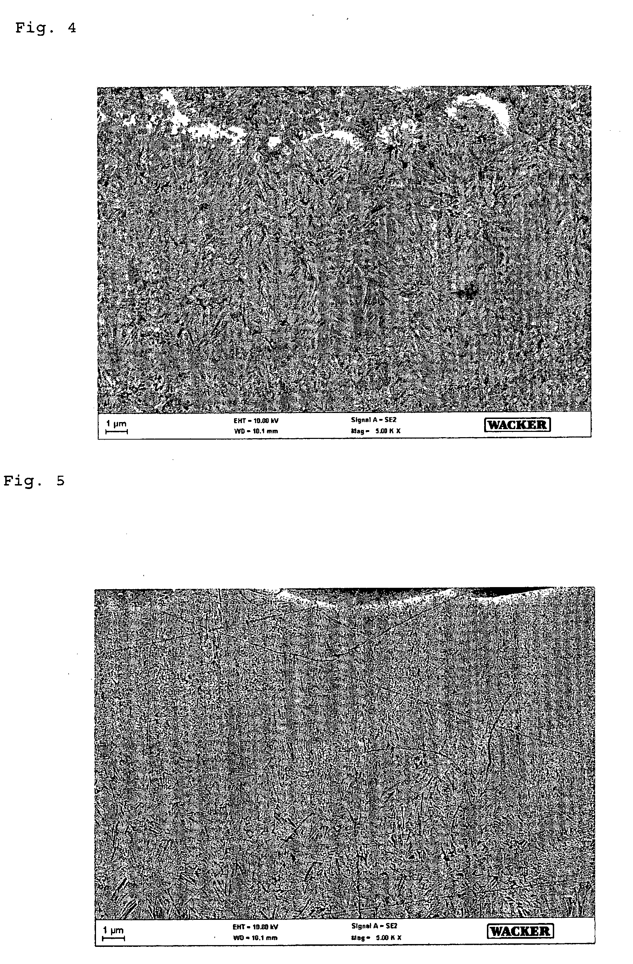

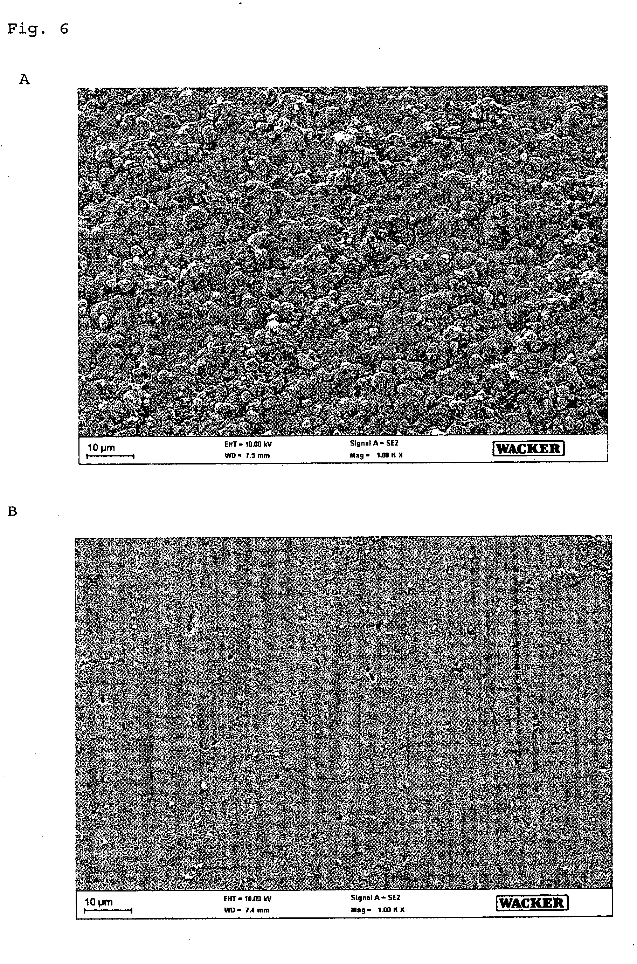

Die Erfindung wird im Folgenden auch anhand von Fig. 1-6 erläutert.
**Fig. 1** zeigt schematisch eine Vorrichtung zur Durchführung des Verfahrens.
**Fig. 2** zeigt schematisch Auskleidung von Rohrleitungen sowie Detektionsbeschichtung.
**Fig. 3** zeigt schematisch Matrix und Oberflächenschicht eines polykristallinen Siliciumgranulats.
**Fig. 4** zeigt REM-Aufnahme von Granulat mit nadeligradialstrahligen Kristallaggregaten.
**Fig. 5** zeigt REM-Aufnahme von Granulat mit einer Schicht von nadelförmig, parallel angeordneten Kristalliten.
**Fig. 6** zeigt REM-Aufnahmen von Granulat A) ohne Glanzschicht und B) mit Glanzschicht.

Nach einer Abtrennung aus der Gasphase (95) dienen diese kristallinen Nano-Siliciumpartikel (97) als idealer Einsatzstoff für die Herstellung von druckbaren Solarzellen und Lithium-Ionen-Batterien.

Das feststofffreie Abgas (96) wird einer Gasrückgewinnung gemäß dem Stand der Technik zugeführt.

Das Verfahren zur Herstellung des erfindungsgemäßen Granulats zeichnet sich aus durch eine Festbettschüttung mit einer Höhe im Bereich von 100 bis 1000 mm, bevorzugt im Bereich von 100 bis 500 mm und besonders bevorzugt im Bereich von 120 bis 140 mm.

Die Festbettschüttung wird erreicht, indem die Bodengasdüsen (Fluidisiergasdüsen) (10) oder ein Bodengasverteiler die Bodenplatte um 100 mm, bevorzugt mehr als 120 mm überragt.

In diesem Festbettbereich erfolgt keine Wandbeheizung des Reaktors und der Festbettbereich liegt über 10 mm, bevorzugt über 50 mm unterhalb der Wandbeheizung.

Alternative Festbettschüttungen ohne die Bodenplatte überragende Düsen, wie z.B. große Siliciumkugeln oder große Siliciumbruchstücke haben sich als nachteilig herausgestellt, da ein Einfüllen ohne Verunreinigung und ohne Bruch von Apparateteilen technisch nicht möglich ist.

Um Verunreinigungen zu vermeiden, hat sich als besonders vorteilhaft das Einfüllen des Festbettes über die Seeddosierung herausgestellt.

Für eine hohe Produktqualität ist eine besonders hohe Oberflächenreinheit des Festbettmaterials von entscheidender Bedeutung. Daher wird Granulat, das aus dem erfindungsgemäßen Verfahren erzeugt wurde, oder an der Oberfläche geätztes hochreines Silicium eingesetzt.

Um Apparateteile und die Reaktorwand nicht zu beschädigen, hat sich als besonders vorteilhaft ein Festbettmaterial mit einem massenbezogenen Maximaldurchmesser von kleiner 10 mm, bevorzugt kleiner 6 mm herausgestellt.

Um die Oberflächenkontamination der Festbettschüttung möglichst gering zu halten, ist eine mittlere Sphärizität von größer 0,8 bevorzugt, größer 0,9 besonders bevorzugt und größer 0,96 ganz besonders bevorzugt.

Um eine gute Ziehperformance zu erreichen, hat sich als besonders vorteilhaft ein Seed bestehend aus nur einer Seedpartikelfraktion herausgestellt.

Die Ziehperformance des Granulat-Silicium hat sich als besonders gut erwiesen, wenn die Kristallitgröße und Kristallitart des Seedpartikels gleich des aus der Gasphase abgeschiedenen Siliciums war.

Überraschend wurde festgestellt, dass die Kristallitart des Silcium-Granulates durch die Kristallitart der Seedkristalle beeinflusst wird.

Bei der Herstellung dieser Seedkristalle erfolgt der Einsatz von Verbundauskleidungen.

Die Verbundauskleidungen bestehen aus Siliciumbrettern, hergestellt aus hochreinem Mono- oder Polysilicium, und einer dahinter liegenden Polysiliciumschicht, abgeschieden mit einer erhöhten, analytisch detektierbaren, Stickstoffdotierung.

Um eine Kontamination des Seeds und des Produkts stets ausschließen zu können, zeichnet sich das erfindungsgemäße Verfahren durch eine Detektionsbeschichtung zwischen den Rohrleitungen und den Silicium-Auskleidungen aus.

Außerdem findet eine regelmäßige analytische Überwachung der Produktqualität statt.

Als besonders geeigneter Detektionswerkstoff wurde unter Stickstoffdotierung abgeschiedenes Silicium ermittelt.

Es kommen allerdings auch andere analytisch gut messbare und die Produktqualität nicht beeinträchtigende Werkstoffkombinationen in Frage. Geeignet sind insbesondere Hartmetalle wie z.B. Wolfram und Wolframcarbid, Edelstahllegierungen oder Keramiken wie z.B. Zirkonium, Zirkoniumoxid und Aluminiumoxid. Ganz besonders geeignet ist Wolframcarbid.

Stickstoff lässt sich an den Seed und Produktoberflächen durch SIMS Messungen in geringen Spuren gut detektieren und hat gleichzeitig in der Weiterverarbeitung die geringsten negativen Auswirkungen auf die Produktqualität.

Produkt berührende Teile der Armaturen sind aus NBR (Nitril-Butadien-Kautschuk) gefertigt.

Weiterhin wird der Siebtrennschnitt von 500 µm auf über 750 µm angehoben.

Bevorzugt liegt der Siebtrennschnitt im Bereich zwischen 750 und 1500µm, für das Siebunterkorn.

Der Siebtrennschnitt wird so gewählt, dass die Siebunterkornmenge ausreicht für die Herstellung von Seed.

Anschließend erfolgt eine Vermahlung des Siebunterkorns anstelle von Siebzielkorn (mittlere Siebfraktion) in einer Luftstrahlmühle.

Die Luftstrahlmühle ist mit einem hochreinen Werkstoff, bevorzugt mit Silicium, ausgekleidet.

Eine detaillierte Beschreibung eines geeigneten Mahlverfahrens findet sich in US7,490,785.

Durch diese Maßnahme kann eine Kontamination der Seedpartikel mit B, C, Zn, Ti, Mg, W, Fe, Co, Sb und Zr verhindert werden.

Geringste Spuren an Verunreinigungen werden außerdem durch die erhöhten Gasmengen und durch eine gezielt hoch gehaltene Reaktorkopftemperatur von über 400 bevorzugt über 600°C oberflächengereinigt.

Die Reaktorkopftemperatur kann eingestellt werden durch die gewählten Gasmengen, die Wirbelschichttemperatur, die Auswahl an Reaktorisolationswerkstoffen und die Reaktorrohrlänge.

Ein weiterer Vorteil der erfindungsgemäßen Seedherstellung besteht darin, dass das Seed nur aus einer einzigen Partikelfraktion besteht.

Auch erfindungsgemäß ist die Möglichkeit einer Herstellung eines hochreinen Siliciumgranulats mit den oben beschriebenen Eigenschaften, welches zusätzlich eine Oberflächenbehandlung mit einer veränderten Kristallstruktur erhält.

Hergestellt wird diese Oberflächenschicht in einem Granulatreaktor wie bereits beschrieben und mit einem TCS Anteil in Wasserstoff von 1 bis 15 mol%, bevorzugt 5,1 bis kleiner 10 mol%, ganz besonders bevorzugt 5,1 bis 6,9 mol%.

Der Verfahrensschritt ist dadurch gekennzeichnet, dass die dabei verwendete Wirbelschichttemperatur des Beschichtungsreaktors um weniger als +/- 30 °C von der Abscheidetemperatur des Abscheidereaktors (900 bis 970 °C) abweicht.

Im Folgenden wird die Herstellung des erfindungsgemäßen polykristallinen Siliciumgranulats im Detail beschrieben.

In einer ersten Prozesstufe wird Siliciumgranulat in einem Wirbelschichtreaktor (1), mit einem Gasgemisch, mit einem TCS Anteil in Wasserstoff von 20 bis 29 mol % bevorzugt 20,5 bis 24 mol % bei einer Wirbelschichttemperatur (11) von 900 - 970 °C abgeschieden. Das Gasgemisch setzt sich zusammen aus einem Fluidisiergas, bevorzugt Wasserstoff (10) und einem Reaktionsgas, besonders bevorzugt TCS in Wasserstoff (9).

Es entsteht ein Siliciumgranulat mit einer Korngrößenverteilung (12) im Bereich 150 bis 10000 µm, bevorzugt sind 98 Massenprozent im Bereich 600 - 4000 µm, mit einem Massenbezogenen Medianwert (x50,3) im Bereich 1200 bis 2600 µm, dessen gesamte Partikelmatrix aus einem Silicium mit einheitlicher Kristallitgröße, Kristallitform und Reinheit besteht.

Die Kristallitanordnung in der gesamten Matrix weist dabei nadelig-radialstrahlige Kristallaggregate auf.

Außerdem enthält die gesamte Matrix keine Einschlüsse von Nano-Siliciumpartikeln.

In einer zweiten Prozessstufe wird dieses Siliciumgranulat an einer Siebanlage 2 mit mindestens einem Siebdeck in mindestens zwei oder mehr Siebfraktionen geteilt.

Die kleinste Siebfraktion (Siebunterkorn, SUK) wird anschließend in einer Mahlanlage 3 zu Seedpartikeln mit einer Größe im Bereich von 100 bis 1500 µm und einem massenbezogenen Medianwert im Bereich 400 bis 900 µm gemahlen und der ersten Prozesstufe als Seedkristalle zugeführt.

Die Siebfraktion mit einer Partikelgrößenverteilung im Bereich 600 bis 8000 µm, mit einem massenbezogenen Medianwert im Bereich 1200 bis 2600 µm, wird anschließend vorzugsweise verpackt (90).

Es wird vorzugsweise in GFZ- (600-4000 µm, bevorzugt über 98 Massenprozent im Bereich 600-2000 µm, mit einem massenbezogenen Medianwert im Bereich 1200 bis 2600 µm) und Tiegelziehverfahren (600-8000 µm, bevorzugt über 98 Massenprozent im Bereich 600-4000 µm, mit einem massenbezogenen Medianwert im Bereich 1200 bis 2600 µm) eingesetzt.

Erfindungsgemäß kann es in einem weiteren Wirbelschichtreaktor (4), mit einem Gasgemisch, mit einem TCS-Anteil in Wasserstoff von 5,1 bis 6,9 mol % bei einer Wirbelschichttemperatur von 900 - 970 °C oberflächenbehandelt werden.

Die im Wirbelschichtreaktor (4) abgeschiedene Schicht auf der Partikeloberfläche ist dadurch gekennzeichnet, dass die Schicht nadelförmige, parallel angeordnete Kristallite enthält.

Durch die Optimierung der Kristallitform kann die Ziehperformance des oberflächenbehandelten Siliciumgranulates (91), allerdings mit erheblichen Kosten, noch leicht verbessert werden.

Die Oberflächenschicht ist außerdem dadurch gekennzeichnet, dass sie keine Feinstpartikel aus der Gasphasenabscheidung oder Abrieb im Bereich kleiner 10 µm enthält. Diese Feinstpartikel führen zu Nachteilen in der Ziehperformance.

Die Oberflächenschicht ist außerdem dadurch gekennzeichnet, dass Verunreinigungen an ihrer Oberfläche weniger gut haften können.

Sowohl der Wirbelschichtreaktor (1) als auch der Wirbelschichtreaktor (4) sind dadurch gekennzeichnet, dass auf der Bodenplatte des Reaktors ein Festbett (13) aus Granulat-Silicium mit einer Höhe von mehr als 100 mm, bevorzugt mehr als 120 mm liegt.

Die Festbettschüttung wird erreicht, indem die Bodengasdüsen (Fluidisiergasdüsen) (10) oder ein Bodengasverteiler die Bodenplatte um mehr als 100 mm, bevorzugt mehr als 120 mm überragt.

In diesem Festbettbereich erfolgt keine Wandbeheizung des Reaktors und der Festbettbereich liegt über 10 mm unterhalb der Wandbeheizung.

Um Verunreinigungen zu vermeiden wird das Einfüllen des Festbettes über die Seeddosierung (50) ausgeführt.

Für eine hohe Produktqualität ist eine besonders hohe Oberflächenreinheit des Festbettmaterials von entscheidender Bedeutung.

Daher wird Granulat aus dem erfindungsgemäßen Verfahren oder an der Oberfläche geätztes, hochreines Silicium eingesetzt. Letzteres kommt z.B. aus Feinbruch aus dem Siemensverfahren oder aus Granulatverfahren aus dem Stand der Technik.

Um Apparateteile und die Reaktorwand nicht zu beschädigen wird als Festbettmaterial Silicium mit einem massenbezogenen Maximaldurchmesser von kleiner 10 mm eingesetzt.

Um die Oberflächenkontamination der Festbettschüttung möglichst gering zu halten, wird für das eingesetzte Silicium eine mittlere Sphärizität von größer 0,8 bevorzugt, größer 0,9 besonders bevorzugt und größer 0,96 ganz besonders bevorzugt.

Das Festbett senkt durch Wärmeisolation den spezifischen Energiebedarf der Wirbelschichtreaktoren.

Überraschenderweise wurde auch eine deutliche Qualitätsverbesserung hinsichtlich Metall-, Phosphor und Borwerte im Granulat-Silicium durch die Festbettschüttung erreicht.

Das Verfahren ist vorzugsweise dadurch gekennzeichnet, dass zur Erreichung hoher Reinheiten die Rohrleitungen (50) im Zugabesystem und Rohrleitungen im Abzugssystem ausgekleidet sind mit Mono- oder Polysiliciumbrettern (200), welche hergestellt wurden durch Zersägen von Siliciumstäben, abgeschieden mit Hilfe des Siemensverfahren oder in einem FZ- oder Tiegelziehverfahren.

Zur Vermeidung von Verunreinigungen werden zur Detektion von Schadstellen in den Auskleidungen zusätzlich mit Stickstoffdotierung abgeschiedene Siliciumstäbe zu Siliciumbrettern verarbeitet und zwischen Auskleidung und Rohrleitung eingesetzt (201).

Alternativ kommen auch noch andere Detektionsmaterialien zwischen Auskleidungen und Apparatewänden in Frage.

Diese müssen dadurch gekennzeichnet sein, dass sie von hoher Reinheit sind, die Produktqualität nicht mindern, und analytisch gut messbar sind.

Zur Erreichung der hohen Reinheitsanforderungen in der Halbleiterindustrie werden außerdem besondere Absperrarmaturen (60) eingesetzt.

Bei diesen besonderen Absperrarmaturen sind alle Siliciumgranulat berührenden Teile aus dem Werkstoff NBR.

Dieses NBR Nitril-Butadien-Kautschuk ist gefertigt mit besonders niedrigem Metallgehalt (z.B. wenig Zn als Katalysator).

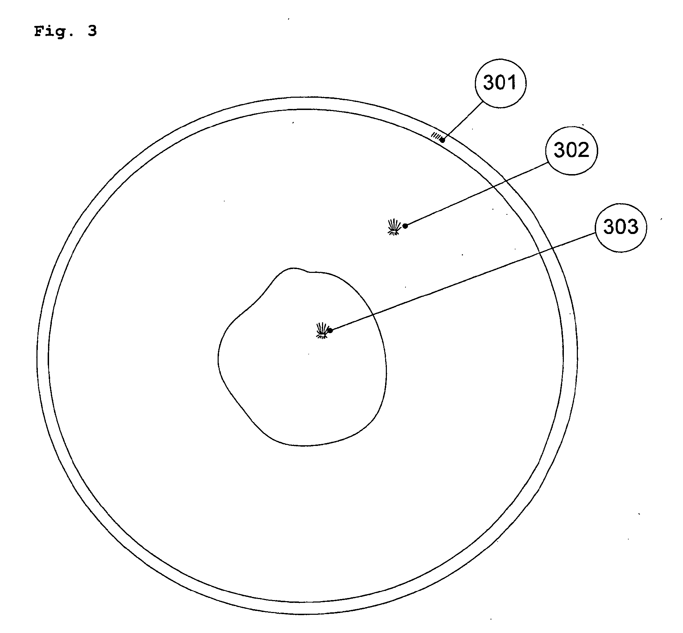

Fig. 3 zeigt schematisch eine Kristallitform, die nadelig-radialstrahlige Kristallaggregate im Partikelinneren aufweist (302 und 303) und eine umliegende dünne Schicht (301) mit nadelförmigen, parallel angeordneten Kristalliten.

Durch die spezielle Kristallitform wird eine signifikant bessere Ziehperformance erreicht.

Das Granulat ist frei von Zn, Zr und Bor wegen Armatur und Rohrleitungsauskleidung mit einer Detektionsschicht aus stickstoffhaltigem Silicium.

Weiterhin ist es Mg- und staubarm wegen schmutzabweisender Oberfläche durch optimierte Kristallitgröße und Kristallitform.

Der Cl-Gehalt beträgt 9 bis 39 ppmw, besonders bevorzugt von 21 bis 35 ppmw und besonders bevorzugt von 21 bis 30 ppmw. Kristallitform und -größe ergeben sich aus rasterelektronenmikroskopischen Aufnahmen in 5000 facher Vergrößerung eines Schliffbildes eines erfindungsgemäßen Polysiliciumgranulats nach Oberflächenätzung (die Polysiliciumgranulatproben werden geschliffen, anschließend poliert und kurz 5 bis 10 Sekunden geätzt mit einer Lösung aus Kaliumdichromat (45g pro Liter Wasser) mit HF 40%ig im Mischungsverhältnis Kaliumdichromatlösung zu HF von 1:2).

Kohlenstoff wird ermittelt nach ASTM 1391-93/2000 an monokristallinen Proben, Bor und Phosphor nach ASTM F1389-00 an monokristallinen Proben, Sb nach ASTM F1630-95 an monokristallinen Proben, Metalle (Zn, Ti, Mg, Zr, W, Fe, Co) analog ASTM 1724-01 mit ICP-MS. Feinstaubmessung erfolgt wie beschrieben in DE2009P00133, Chlormessung mit SEMI PV 10.

Spezifische Oberfläche (Sv) und Partikelgröße (minimale Sehne) werden gemessen mit einem Camsizer von Retsch Technology (Messprinzip: Dynamische Bildanalyse nach ISO 13322-2, Messbereich: 30 µm - 30 mm, Art der Analyse: Trockenmessung von Pulvern und Granulaten).

Stickstoff wird gemessen mit SIMS-Analyse, nach AN456 von EAG.

Wasserstoff wird bestimmt mittels Gas Fusion Analysis nach ASTM E 1447.

Die BET-Oberfläche wird analog ASTM D1993 ermittelt.

Die Oxidschichtdicke wird mittels Elektron-Energieverlust-Spektroskopie gemessen, bei ausreichend dicken Oxidschichten mit einem Ellipsometer nach ASTM 576.

Die Lebensdauermessung erfolgt in Anlehnung SEMI AUX017 an monokristallinen Proben.

### Beispiele

Es wurden zahlreiche Versuche durchgeführt mit unterschiedlichen Prozessbedingungen.

Die erfindungsgemäßen Beispiele sowie Vergleichsbeispiele mit allen wichtigen Prozessparametern sowie Charakterisierungsdaten des hergestellten Granulats sind den **Tabellen 1-3** zu entnehmen.

**Tabelle 1** zeigt Positiv-Beispiel 1 und 2 für Kristallitform: nadelig-radialstrahlige Kristallaggregate und Vergleichsbeispiel (Negativbeispiel) 1 für Kristallitform: nadelig-radialstrahlige und parallele Kristallaggregate.

**Tabelle 2** zeigt Positiv-Beispiel 3 Kristallitform: nadelig-radialstrahlige Kristallaggregate im Partikelinneren und nadelförmige, parallel angeordnete Kristallite in einer umliegenden dünnen Schicht und Vergleichsbeispiel 2 für Kristallitform: nadelig-radialstrahlige Kristallaggregate im Partikelinneren und nadelförmige, parallel und radialstrahlig angeordnete Kristallite in einer umliegenden dünnen Schicht.

**Tabelle 3** zeigt Positiv-Beispiel 4 und Vergleichsbeispiel 3 für Kristallitform: nadelförmige, parallel angeordnete Kristallite.

**Tabelle 1**

| | negativ Beispiel 1 | **negativ Beispiel 1** | **positiv Beispiel 2** |
|---|---|---|---|
| Verfahrensparameter | 1 | 1 | 2 |
| Durchmesser Reaktor 1 [mm] | 600 | 600 | 600 |
| TCS-Massenstrom (9) [kg/] | 400 | 710 | 3500 |
| H2-Volumenstrom (9) [Nm3/h] | 135 | 135 | 650 |
| H2-Volumenstrom (10) [Nm3/h] | 310 | 310 | 1550 |
| Bettgewicht [kg] | 250 | 250 | 350 |
| Reaktorheizleistung [kW] | 308 | 308 | 1200 |
| Seeddosierrate [kg/h] | 2,5 | 4,5 | 21 |
| Wirbelschichttemperatur [°C] | 971 | 960 | 955 |
| Siebschnitt (Siebmaschenweite) [mm] | 450 | 750 | 1400 |
| Zielprodukt massenbezogener Medianwert | 1180 | 1300 | 2600 |
| Siebunterkorn massenbezogener Medianwert | 380 | 650 | 1300 |
| **Seed aus** | Mahlung Siebzielkorn + Siebunterkorn | **Mahlung Siebunterkorn** | **Mahlung Siebunterkorn** |
| massenbezogener Medianwert Seed | 380 | 450 | 900 |
| Produktabfüllung | unter Reinraumluft | unter Inertgas | **unter Inertgas** |
| **Reaktorrohrauskleidungen** | **PFA und Quarzglas** | **Silicium/N-Silicium** | **Silicium/N-Silicium** |
| **Bodendüsenöffnung über Boden [mm]** | 0 | 120 | 130 |
| | | | |

| Produktparameter | Produktparameter | | |
|---|---|---|---|
| Summe Zn, Ti, Mg, Zr, W, Fe, Co, Sb: ppbw | 11 | 0,8 | 0,1 |
| Kohlenstoff: ppma | 1 | 0,011 | 0,002 |
| Kohlenstoff im Bulk: ppma | 0,02 | 0,002 | 0,001 |
| Bor: ppba | 0,1 | 0,003 | 0,005 |
| Feinstaub ppmw | 20 | 9 | 8 |
| spezifische Oberfläche cm2/g | 31 | 23 | 7 |
| Wasserstoffgehalt des Silicium-Ganulat: ppmw | 50 | 0,9 | 0,03 |
| Ziehperformance: | hohe Versetzungsrate | niedrige Versetzungsrate | keine Versetzungen |
| Kristallitform im inneren (Partikelmatrix): | nadelig, parallel und radialstrahlige Kristallite | nadelig, radialstrahlige Kristallite | nadelig, radialstrahlige Kristallite |
| Kristallitform in der dünnen äußeren Schicht: | nadelig, parallel und radialstrahlige Kristallite | nadelig, radialstrahlige Kristallite | nadelig, radialstrahlige Kristallite |

**Tabelle 2**

| | | |
|---|---|---|
| | **negativ Beispiel 2** | **positiv Beispiel 3** |
| Verfahrensparameter | 1 | 3 |
| **Durchmesser Reaktor 1[mm]** | 600 | 600 |
| TCS-Massenstrom [kg/] | 710 | 710 |
| H2-Volumenstrom (9)[Nm3/h] | 135 | 135 |
| H2-Volumenstrom (10) [Nm3/h] | 310 | 310 |
| Bettgewicht [kg] | 250 | 250 |
| Reaktorheizleistung [kW] | 308 | 308 |
| Seeddosierrate [kg/h] | 4,5 | 4,5 |
| Wirbelschichttemperatur [°C] | 980 | 950 |
| Siebschnitt (Siebmaschenweite) [mm] | 650 | 750 |
| Zielprodukt massenbezogener Medianwert | 1220 | 1300 |
| Siebunterkorn massenbezogener Medianwert | 640 | 660 |
| **Seed aus** | Mahlung Siebzielkorn + Siebunterkorn | Mahlung Siebzielkorn + Siebunterkorn |
| massenbezogener Medianwert Seed | 390 | 450 |
| Produktabfüllung | **unter Reinraumluft** | **unter Reinraumluft** |
| **Durchmesser Reaktor 2 [mm]** | 400 | 400 |
| TCS-Massenstrom (39) [kg/] | 220 | 65 |
| H2-Volumenstrom (39) [Nm3/h] | 53 | 53 |
| H2-Volumenstrom (40) [Nm3/h] | 125 | 125 |
| Bettgewicht [kg] | 110 | 110 |
| Reaktorheizleistung [kW] | 120 | 120 |
| Seeddosierrate [kg/h] | 20 | 20 |
| Wirbelschichttemperatur [°C] | 960 | 940 |
| Seed aus | Siebzielkorn Reaktor 1 | Siebzielkorn Reaktor 1 |
| Produktabfüllung | **unter Reinraumluft** | **unter Reinraumluft** |
| **Reaktorrohrauskleidungen** | Quarzglas | **Silicium/N-Silicium** |
| **Bodendüsenöffnung über Boden [mm]** | 50 | 150 |

| Produktparameter | | |
|---|---|---|
| Summe Zn, Ti, Mg, Zr, W, Fe, Co, Sb: ppbw | 1,6 | 0,7 |
| Kohlenstoff: ppma | 0,110 | 0,003 |
| Kohlenstoff im Bulk: ppma | 0,02 | 0,002 |
| Bor: ppba | 0,09 | 0,004 |
| Feinstaub ppmw | 11 | 0,04 |
| spezifische Oberfläche cm2/g | 31 | 21 |
| Wasserstoffgehalt des Silicium-Ganulat: ppmw | 47 | 15 |
| Ziehperformance: | unwirtschaftlich, Versetzungsrate | niedrige Versetzungsrate |
| Kristallitform im inneren (Partikelmatrix): | nicht erkennbar | nadelförmig parallel angeordnete Kristallite |
| Kristallitform in der dünnen äußeren Schicht: | nicht erkennbar | nadelförmig parallel angeordnete Kristallite |

**Tabelle 3**

| | **negativ Beispiel 3** | **positiv Beispiel 4** |
|---|---|---|
| Verfahrensparameter | 1 | 3 |
| Durchmesser Reaktor 1[mm] | 400 | 400 |
| TCS-Massenstrom [kg/] | 5 | 65 |
| H2-Volumenstrom (9)[Nm3/h] | 53 | 53 |
| H2-Volumenstrom (10)[Nm3/h] | 125 | 125 |
| Bettgewicht [kg] | 110 | 110 |
| Reaktorheizleistung [kW] | 120 | 120 |
| Seeddosierrate [kg/h] | 0,1 | 1 |
| Wirbelschichttemperatur [°C] | 975 | 940 |
| Siebschnitt (Siebmaschenweite) [mm] | 700 | 750 |
| Zielprodukt massenbezogener Medianwert | 1220 | 1300 |
| Siebunterkorn massenbezogener Medianwert | 645 | 650 |
| **Seed aus** | Mahlung Siebzielkorn + Siebunterkorn | **Mahlung Siebunterkorn** |
| massenbezogener Medianwert Seed | 399 | 430 |
| Produktabfüllung | **unter Reinraumluft** | **unter Inertgas** |
| **Reaktorrohrauskleidungen** | Quarzglas | **Silicium/N-Silicium** |
| **Bodendüsenöffnung über Boden [mm]** | 50 | 140 |
| | | |

| Produktparameter | | |
|---|---|---|
| Summe Zn, Ti, Mg, Zr, W, Fe, Co, Sb: ppbw | 1,6 | 0,7 |
| Kohlenstoff: ppma | 0,110 | 0,003 |
| Kohlenstoff im Bulk; ppma | 0,02 | 0,002 |
| Bor: ppba | 0,09 | 0,004 |
| Feinstaub ppmw | 11 | 0,04 |
| spezifische Oberfläche cm2/g | 31 | 21 |
| Wasserstoffgehalt des Silicium-Ganulat: ppmw | 47 | 15 |
| Ziehperformance: | unwirtschaftlich, Versetzungsrate | niedrige Versetzungsrate |
| Kristallitform im inneren (Partikelmatrix): | nicht erkennbar | nadelförmig parallel angeordnete Kristallite |
| Kristallitform in der dünnen äußeren Schicht: | nicht erkennbar | nadelförmig parallel angeordnete Kristallite |

## Patentansprüche

1. Polykristallines Siliciumgranulat, umfassend eine kompakte Matrix und eine Oberflächenschicht enthaltend nadelförmige, parallel angeordnete Kristallite.

2. Polykristallines Siliciumgranulat nach Anspruch 1, wobei die kompakte Matrix nadelig-radialstrahlige Kristallaggregate umfasst.

3. Polykristallines Siliciumgranulat nach Anspruch 1, wobei die kompakte Matrix nadelförmige, parallel angeordnete Kristallite beinhaltet.

4. Polykristallines Siliciumgranulat nach einem der Ansprüche 1 bis 3, frei von Einschlüssen von Feinstpartikeln im Größenbereich von kleiner 10 µm.

5. Polykristallines Siliciumgranulat nach einem der Ansprüche 1 bis 4, mit einer Partikelgröße von 150 µm bis 10 mm.

6. Verfahren zur Herstellung von polykristallinem Siliciumgranulat nach den Ansprüchen 1 bis 5, umfassend a) Erzeugung von Siliciumgranulat in einem Wirbelschichtreaktor aus einem Gasgemisch, enthaltend TCS und Wasserstoff mit einem TCS-Anteil von 20 bis 29 mol%, bei einer Wirbelschichttemperatur von 900 - 970 °C und einer Gasgeschwindigkeit von 0,7 bis 2,1 m/s, wobei in einer ersten Stufe Seeds aus hochreinem Silicium zum Einsatz kommen, b) Teilen des dabei erhaltenen Siliciumgranulats an einer Siebanlage enthaltend mindestens ein Siebdeck in mindestens zwei oder mehr Siebfraktionen, wobei eine geeignete Siebfraktion mit einem Medianwert kleiner dem Medianwert des in der ersten Stufe hergestellten Siliciumgranulats in einer Mahlanlage zu Seedpartikeln mit einer Größe von 100 bis 1500 µm und einem massenbezogenen Medianwert im Bereich 400 bis 900 µm gemahlen wird und c) wobei diese Seedpartikel in einer zweiten Stufe Wirbelschichtreaktor (1) zugeführt werden.

7. Verfahren nach Anspruch 6, wobei eine weitere Siebfraktion mit einer Partikelgrößenverteilung im Bereich 600 bis 8000 µm und einem massenbezogenen Medianwert im Bereich 1200 bis 2600 µm, einem Wirbelschichtreaktor (4) zugeführt wird, die mit einem Gasgemisch, enthaltend TCS und Wasserstoff mit einem TCS-Anteil von 5,1 bis weniger als 10 mol % bei einer Wirbelschichttemperatur von 870- 990 °C oberflächenbehandelt wird.

8. Verfahren nach Anspruch 6 oder nach Anspruch 7, wobei in Wirbelschichtreaktor (1,4) auf einer Bodenplatte des Reaktors ein Festbett (13) aus Granulat-Silicium mit einer Höhe von mehr als 100 mm liegt, wobei das eingesetzte Silicium eine mittlere Sphärizität von größer 0,8 bevorzugt, größer 0,9 besonders bevorzugt und größer 0,96 ganz besonders bevorzugt.

9. Verfahren nach einem der Ansprüche 6 bis 8, wobei Rohrleitungen (50) im Zugabesystem und Rohrleitungen im Abzugssystem mit Mono- oder Polysiliciumbrettern (200) ausgekleidet sind, wobei zwischen Auskleidung und Rohrleitung mit Stickstoffdotierung abgeschiedene, zu Siliciumbrettern verarbeitete Siliciumstäbe (201) vorgesehen sind.

10. Verfahren nach einem der Ansprüche 6 bis 9, wobei Absperrarmaturen (60) eingesetzt werden, deren das Siliciumgranulat berührende Teile aus dem Werkstoff NBR bestehen.

## Claims

1. Granular polycrystalline silicon comprising a compact matrix and a surface layer comprising acicular crystals arranged in parallel.

2. Granular polycrystalline silicon according to Claim 1, wherein the compact matrix comprises radiating acicular crystal aggregates.

3. Granular polycrystalline silicon according to Claim 1, wherein the compact matrix comprises acicular crystals arranged in parallel.

4. Granular polycrystalline silicon according to any of Claims 1 to 3, free of inclusions of ultrafine particles within the size range of less than 10 µm.

5. Granular polycrystalline silicon according to any of Claims 1 to 4 having a particle size of 150 µm to 10 mm.

6. Process for producing granular polycrystalline silicon according to Claims 1 to 5, comprising a) producing granular silicon in a fluidized bed reactor from a gas mixture comprising TCS and hydrogen with a TCS content of 20 to 29 mol% at a fluidized bed temperature of 900 - 970°C and a gas velocity of 0.7 to 2.1 m/s, using seeds of high-purity silicon in a first stage, b) dividing the granular silicon obtained in a screen system comprising at least one screen deck into at least two or more than two screen fractions, and grinding a suitable screen fraction having a median value less than the median value of the granular silicon produced in the first stage in a grinding system to give seed particles having a size of 100 to 1500 µm and a mass-based median value in the range of 400 to 900 µm, and c) supplying these seed particles to fluidized bed reactor (1) in a second stage.

7. Process according to Claim 6, wherein a further screen fraction having a particle size distribution in the range of 600 to 8000 µm and a mass-based median value in the range of 1200 to 2600 µm is supplied to a fluidized bed reactor (4) and is surface-treated with a gas mixture comprising TCS and hydrogen with a TCS content of 5.1 to less than 10 mol% at a fluidized bed temperature of 870-990°C.

8. Process according to Claim 6 or according to Claim 7, wherein a fixed bed (13) of granular silicon having a height of more than 100 mm lies on a base plate of the reactor in fluidized bed reactors (1, 4), the silicon used having a mean sphericity of preferably greater than 0.8, more preferably greater than 0.9 and most preferably greater than 0.96.

9. Process according to any of Claims 6 to 8, wherein pipelines (50) in the addition system and pipelines in the removal system are lined with mono- or polysilicon boards (200), with provision of silicon rods (201) processed to silicon boards, deposited with nitrogen doping between lining and pipeline.

10. Process according to any of Claims 6 to 9, wherein shut-off valves (60) are used, the parts of which in contact with the granular silicon consist of the material NBR.

## Revendications

1. Granulat de silicium polycristallin, comprenant une matrice compacte et une couche de surface contenant des cristaux en forme d'aiguille, disposés parallèlement.

2. Granulat de silicium polycristallin selon la revendication 1, la matrice compacte comprenant des agrégats de cristaux en forme d'aiguilles disposées radialement.

3. Granulat de silicium polycristallin selon la revendication 1, la matrice compacte comprenant des cristaux en forme d'aiguilles, disposés parallèlement.

4. Granulat de silicium polycristallin selon l'une quelconque des revendications 1 à 3, exempt d'inclusions de particules fines dans la plage de grosseurs inférieure à 10 µm.

5. Granulat de silicium polycristallin selon l'une quelconque des revendications 1 à 4, présentant une grosseur de particule de 150 µm à 10 mm.

6. Procédé pour la production de granulat de silicium polycristallin selon les revendications 1 à 5, comprenant a) la production de granulat de silicium dans un réacteur à couche tourbillonnante à partir d'un mélange gazeux contenant du TCS et de l'hydrogène, présentant une proportion de TCS de 20 à 29% en mole, à une température de la couche tourbillonnante de 900-970°C et à une vitesse des gaz de 0,7 à 2,1 m/s, des semences de silicium de haute pureté étant utilisées dans un premier étage, b) la répartition du granulat de silicium ainsi obtenu, sur une installation de tamisage contenant au moins un plateau de tamisage, en au moins deux fractions de tamisage ou plus, une fraction de tamisage appropriée présentant une valeur médiane inférieure à la valeur médiane du granulat de silicium préparé dans le premier étage étant broyée dans une installation de broyage en particules de semence présentant une grosseur de 100 à 1500 µm et une valeur médiane par rapport à la masse dans la plage de 400 à 900 µm et c) ces particules de semence étant introduites dans un deuxième étage du réacteur à couche tourbillonnante (1).

7. Procédé selon la revendication 6, une autre fraction de tamisage, présentant une répartition des grosseurs de particule dans la plage de 600 à 8000 µm et une valeur médiane par rapport à la masse dans la plage de 1200 à 2600 µm, étant introduite dans un réacteur à couche tourbillonnante (4) et traitée en surface à l'aide d'un mélange de gaz, contenant du TCS et de l'hydrogène, présentant une proportion de TCS de 5,1 à moins de 10% en mole à une température de la couche tourbillonnante de 870-990 °C.

8. Procédé selon la revendication 6 ou selon la revendication 7, un lit fixe (13) de granulat de silicium présentant une hauteur de plus de 100 mm étant situé dans le réacteur à couche tourbillonnante (1, 4) sur une plaque de fond du réacteur, le silicium utilisé présentant une sphéricité moyenne de préférence supérieure à 0,8, de manière particulièrement préférée supérieure à 0,9 et de manière tout particulièrement préférée supérieure à 0,96.

9. Procédé selon l'une quelconque des revendications 6 à 8, des conduites tubulaires (50) dans le système d'alimentation et des conduites tubulaires dans le système d'évacuation étant revêtues de panneaux de monosilicium ou de polysilicium (200), des barres de silicium (201), déposées avec un dopage à l'azote, transformées en panneaux de silicium, étant prévues entre le revêtement et les conduites tubulaires.

10. Procédé selon l'une quelconque des revendications 6 à 9, des armatures d'arrêt (60) étant utilisées, dont les parties en contact avec le granulat de silicium sont constituées du matériau NBR.
